# EUROPEAN PATENT SPECIFICATION

(11) **EP 1 349 006 B1**
(45) Date of publication and mention of the grant of the patent: **25.09.2013**
(21) Application number: 02100316.5
(22) Date of filing: 28.03.2002
(51) Int. Cl.: G03F 7/031, G03F 7/029

(54) **Photopolymerizable composition sensitized for the wavelength range from 300 to 450 nm.**
Fotopolymerisierbare Zusammensetzung, die im Wellenlängenbereich von 300 bis zu 450 nm sensibilisiert ist
Composition photopolymerisable sensibilisée au domaine de longueurs d'onde comprises entre 300 et 450 nm

(43) Date of publication of application: 01.10.2003
(73) Proprietor: Agfa Graphics N.V., 2640 Mortsel (BE)
(72) Inventor: Gries, Willi-Kurt, c/o AGFA-GEVAERT, 2640 Mortsel (BE); Thorsten, Lifka, c/o AGFA-GEVAERT, 2640 Mortsel (BE)
(74) Representative: Goedeweeck, Rudi

(56) References cited:
- EP-A- 0 741 331
- EP-A- 0 741 333
- WO-A-97/35232
- DE-A- 19 907 957

## Description

### FIELD OF THE INVENTION

The present invention relates to a printing plate precursor comprising a photopolymerizable composition which is sensitized for the wavelength range from 300 to 450 nm and which comprises an optical brightening agent as sensitizer. The invention also relates to a method for making a printing plate therewith.

### BACKGROUND OF THE INVENTION

From DE 199 07 957, WO 97/35232 and EP 0.741 333 photopolymerizable compositions comprising a combination of special phosphin oxide photoinitiators and an optical brightener are known, that can preferably be used as white lacquer or color proofing material. EP 0 741 331 discloses a strippable color proofing element with a complex layer assembly comprising seven layers and at least in a layer called color layer or in a layer called photoadhering layer comprises at least one special photoinitiator which may also comprise a fluorescent optical brightener. The sensitivity of the compositions and materials as disclosed in DE 199 07 957, WO 97/35232, EP 0 741 333 and EP 0 741 331 is unsufficient for a low-power exposure and they are usually photohardened by means of a high-power lamp like a mercury vapor discharge lamp, a metal halide lamp or a xenon lamp.

In lithographic printing, a so-called printing master such as a printing plate is mounted on a cylinder of the printing press. The master carries a lithographic image on its surface and a printed copy is obtained by applying ink to said image and then transferring the ink from the master onto a receiver material, which is typically paper. In conventional, so-called "wet" lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called "driographic" printing, the lithographic image consists of ink-accepting and ink-abhesive (ink-repelling) areas and during driographic printing, only ink is supplied to the master.

Printing masters are generally obtained by the so-called computer-to-film (CtF) method wherein various pre-press steps such as typeface selection, scanning, color separation, screening, trapping, layout and imposition are accomplished digitally and each color selection is transferred to graphic arts film using an imagesetter. After processing, the film can be used as a mask for the exposure of an imaging material called plate precursor and after plate processing, a printing plate is obtained which can be used as a master. Since about 1995, the so-called 'computer-to-plate' (CtP) method has gained a lot of interest. This method, also called 'direct-to-plate', bypasses the creation of film because the digital document is transferred directly to a plate precursor by means of a so-called plate-setter. A plate precursor for CtP is often called a digital plate.

Digital plates can roughly be divided in three categories : (i) silver plates, which work according to the silver salt diffusion transfer mechanism; (ii) photopolymer plates which contain a photopolymerizable composition that hardens upon exposure to light and (iii) thermal plates of which the imaging mechanism is triggered by heat or by light-to-heat conversion. Thermal plates are mainly sensitized for infrared lasers emitting at 830 nm or 1064 nm. Typical photopolymer plates are sensitized for visible light, mainly for exposure by an Ar laser (488 nm) or a FD-YAG laser (532 nm). The wide-scale availability of low cost blue or violet laser diodes, originally developed for data storage by means of DVD, has enabled the production of plate-setters operating at shorter wavelength. More specifically, semiconductor lasers emitting from 350 to 450 nm have been realized using an InGaN material.

Photopolymer plates sensitized for the wavelength range from 350 to 450 nm have also been described in the prior art. Photopolymer plates generally contain a polymerizable monomer, a binder, a photoinitiator and a sensitizing dye. EP-A 985683 describes a composition comprising a titanocene compound as photoinitiator and specific dyes as sensitizers for the wavelength range from 350 to 450 nm. EP-A 1035435 discloses a 1,3-dihydro-1-oxo-2H-indene derivative as sensitizing dye. EP-As 1048982 and 1070990 also discloses certain dyes in combination with a titanocene photoinitiator. A wide range of dyes for the wavelength range from 300 to 1200 nm is disclosed in EP-A 1091247. The sensitizing dyes disclosed in the prior art do not produce sufficient speed (sensitivity) to enable a short exposure time with the commercially available blue or violet laser diodes. Typical low-cost blue or violet laser diodes have a light output characterized by low power. In the prior art, the examples are exposed by means of a xenon lamp or a high-power, and therefore more expensive blue or violet laser diode.

### SUMMARY OF THE INVENTION

It is an object of the present invention to provide a highspeed composition that is photopolymerizable upon absorption of light in the wavelength range between 300 and 450 nm and that enables one to produce imaging materials, such as printing plate precursors or photoresist materials, which are exposable by low-cost lasers operating in that wavelength range. That object is realized by the composition defined in claim 1. According to the present invention, the use of an optical brightening agent as sensitizer for the wavelength range from 300 to 450 nm enables one to obtain a highspeed photopolymerizable composition. When said composition is coated on a suitable support, a printing plate precursor according to the present invention is obtained that is sensitive to the wavelength range from 300 to 450 nm. The printing plate precursor of the present invention is a flexographic or lithographic printing plate precursor, the latter being highly preferred. Also a method of making a printing plate wherein said printing plate precursor is exposed with a laser having an emission in the wavelength range from 300 to 450 nm, is an aspect of the present invention. Preferred photopolymer plate precursors according to the present invention can be exposed with an energy density, measured on the surface of the plate of 100 µJ/cm² or less. Preferred embodiments of the composition, of the printing plate precursor, of the method of making a printing plate and of the use according to the present invention are defined in the dependent claims.

### DETAILED DESCRIPTION OF THE INVENTION

The photopolymerizable composition according to the invention contains an optical brightening agent as a sensitizer, a photoinitiator, a binder and a polymerizable compound. A typical optical brightener, also known as "fluorescent whitening agent", is a colorless to weakly colored organic compound that is capable of absorbing light having a wavelength in the range between 300 and 450 nm and of emitting the absorbed energy as fluorescent light having a wavelength in the range between 400 and 500 nm. A description of the physical principle and the chemistry of optical brighteners is given in Ullmann's Encyclopedia of Industrial Chemistry, Sixth Edition, Electronic Release, Wiley-VCH 1998. Basically, suitable optical brightener contain π-electron systems comprising a carbocyclic or a heterocyclic nucleus. Suitable representatives of these compounds are e. g. stilbenes, distyrylbenzenes, distyrylbiphenyls, divinylstilbenes, triazinylaminostilbenes, stilbenyltriazoles, stilbenylnaphthotriazoles, bis-triazolstilbenes, benzoxazoles, bisphenylbenzoxazoles, stilbenylbenzoxazoles, bis-benzoxazoles, furans, benzofurans, bis-benzimidazoles, diphenylpyrazolines, diphenyloxadiazoles, coumarins, naphthalimides, xanthenes, carbostyrils, pyrenes and 1,3,5-triazinyl-derivatives.

The optical brightening agents having a structure according to one of the following formulae are used as sensitizer in the composition of the present invention : 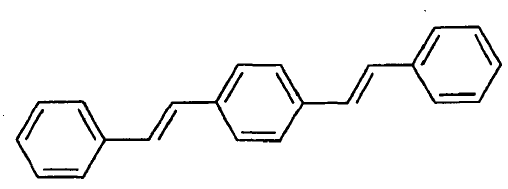 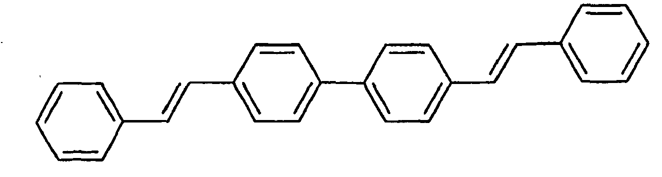 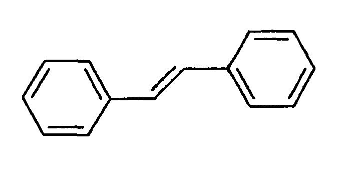 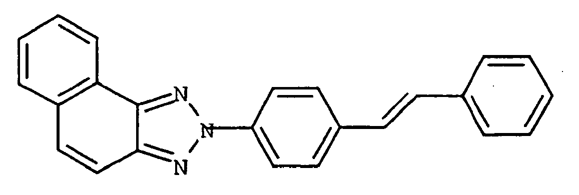 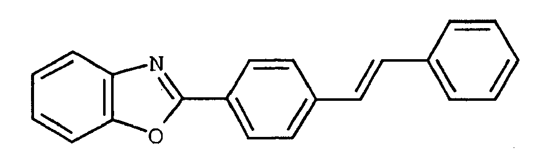 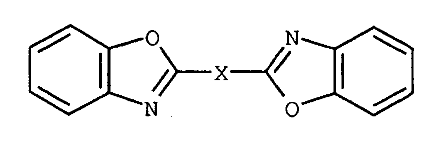 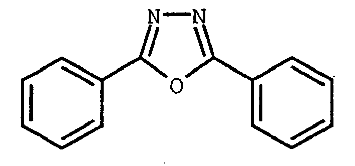 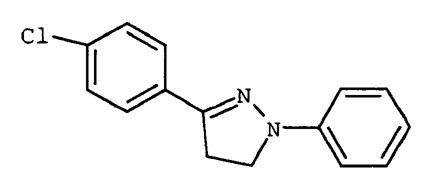 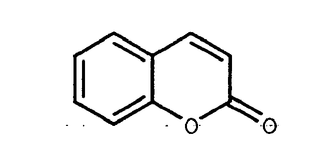 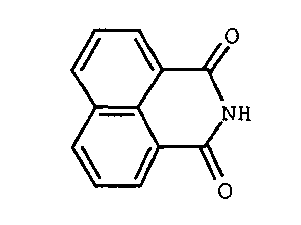 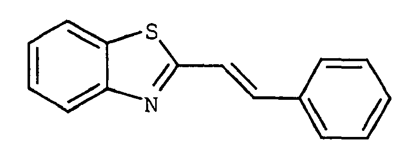 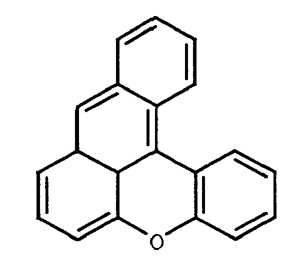 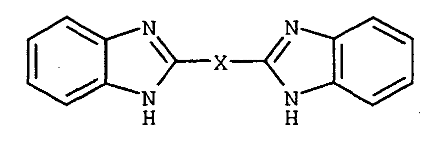 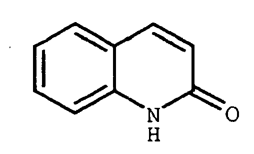 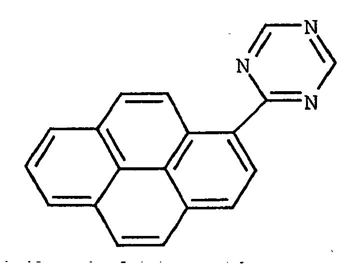 wherein X is one of the following groups, * denoting the position of attachment in the above formulae : 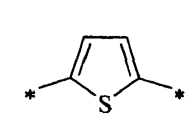 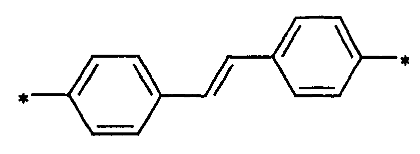 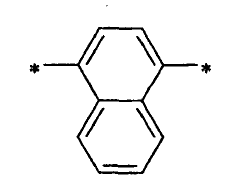 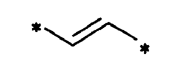 wherein one or more of the nuclei in each of the above formulae may be independently substituted by one or more groups selected from alkyl, alkoxy, alkylcarbonyl, alkoxycarbonyl, acyloxy, carboxyl, nitrile, amino, hydroxyl, alkylsulfonyl and aminosulfonyl.

Especially suitable optical brighteners are compounds, which are able to be dissolved in organic solvents. The optical brighteners can be used as single compound or as mixture of several materials. The overall amount of these compounds range from 0.1 to 10 % by weight, preferably 0.5 to 8 % by weight with respect to the total weight of the non-volatile compounds in the composition. Highly preferred optical brighteners include : 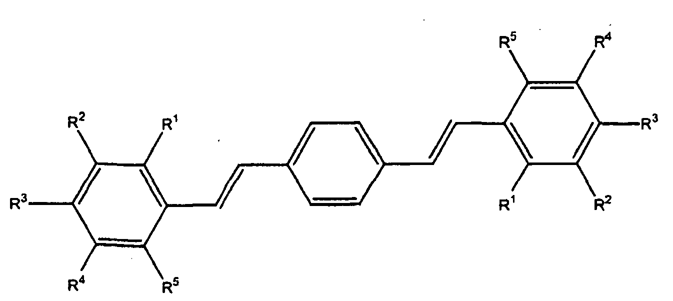 wherein
a) R¹ = Me, R² - R⁵ = H; or
b) R² - R⁴ = OMe, R¹ = R⁵ = H; or
c) R¹ = CN, R² - R⁵ = H; or
d) R³ = CN, R¹ = R² = R⁴ = R⁵ = H. 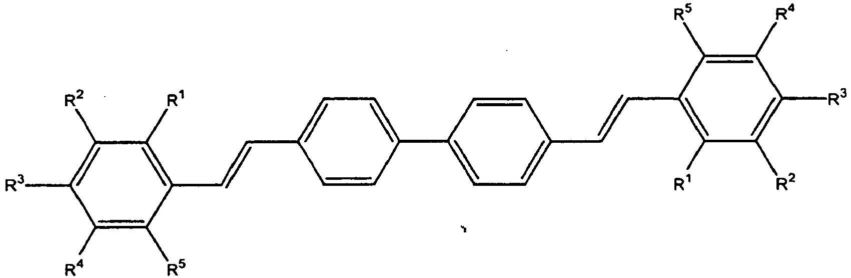
wherein R¹ - R⁴ = H, R⁵ = OMe. 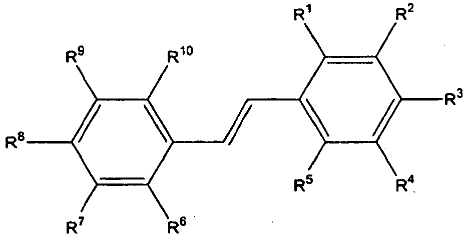 wherein
a) R¹ - R¹⁰ = H; or
b) R¹, R², R⁴ - R¹⁰ = H, R³ = OMe; or
c) R¹, R², R⁴ - R⁷, R⁹, R¹⁰ = H, R³, R⁸ = OMe.

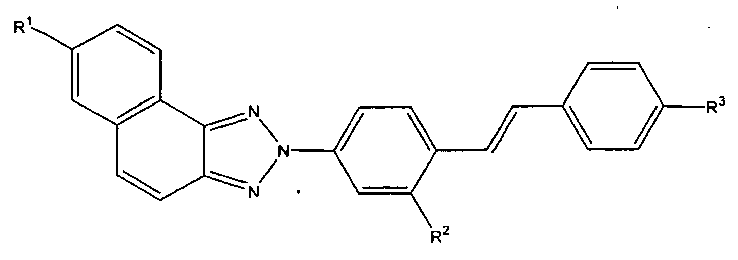

wherein
a) R¹ = R³ = H, R² = SO₃Ph; or
b) R¹ = H, R² = CN, R³ = Cl. 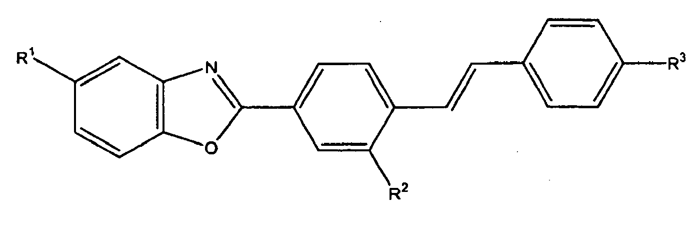
wherein
a) R¹ = tBu, R² = H, R³ = Ph; or
b) R¹ = Me, R² = H, R³ = COOMe; or
c) R¹ = H, R² = H, R³ = 2-(4-methyl-oxa-3,3-diazole). 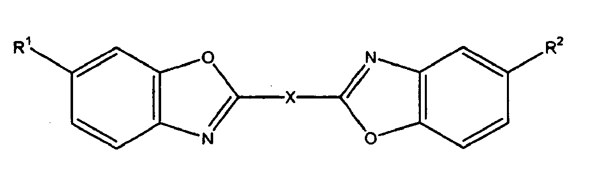
wherein
a) X = 4,4'-stilbenediyl, R¹ = R² = H; or
b) X = 2,5-thiophenediyl, R¹ = R² = tBu; or
c) X = 1,4-naphthalenediyl, R¹ = R² = H; or
d) X = 1,1-ethenediyl, R¹ = R² = Me. 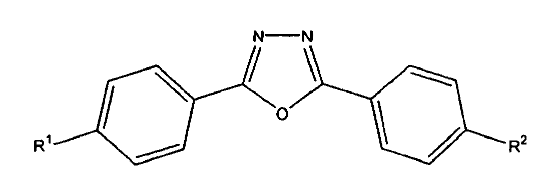
wherein R¹ = R² = NEt₂. 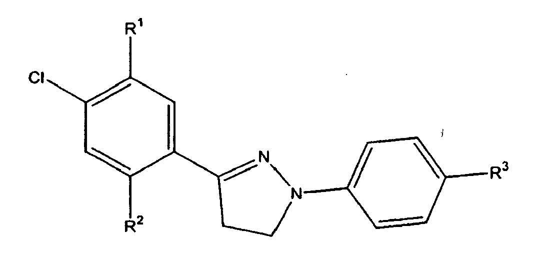 wherein
a) R¹ = R² = H, R³ = SO₂NH₂; or
b) R¹ = R² = H, R³ = SO₂CH₂CH₂OCH₂CH₂NMe₂; or
c) R¹ = R² = H, R³ = SO₂CH₂CH₂OCH(CH₃)CH₂NMe₂; or
d) R¹ = R² = H, R³ = SO₂CH₃; or
e) R¹ = R² = H, R³ = SO₂CH₂CH₂OH. 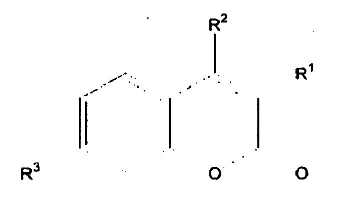
wherein
a) R¹ = H, R² = Me, R³ = NEt₂; or
b) R¹ = Ph, R² = H, R³ = 2-N-naphthatriazolyl; or
c) R¹ = H, R² = Me, R³ = OH; or
d) R¹ = Ph, R² = H, R³ = NH-(4,6-dichloro)-(1,3,5)-triazine; or
e) R¹ = Ph, R² = H, R³ = 1-(3-methylpyrazolinyl). 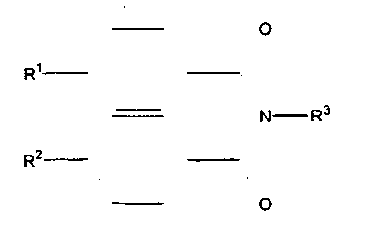
wherein
a) R¹ = H, R² = OMe, R³ = Me; or
b) R¹ = R² = OEt, R³ = Me. 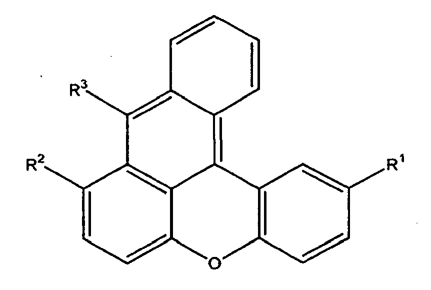
wherein
a) R¹ = Me, R² = Me, R³ = H; or
b) R¹ = R² = Me, R³ = OCOMe. 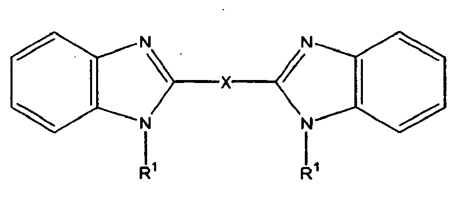
wherein
a) X = 1,2-ethenediyl, R¹ = Me; or
b) X = 4,4'-stilbenediyl, R¹ = Me. 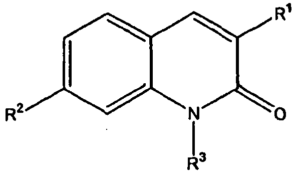
wherein R¹ = Ph, R² = NEt₂, R³ =Et. 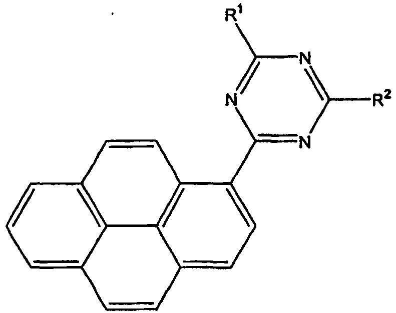 wherein R¹ = R² = OMe.

The photopolymerization initiator hexaarylbisimidazole (HABI, dimer of triarylimidazole) is used in the composition of the present invention. Other classes of initiators known in the art include aromatic ketones, aromatic onium salts, organic peroxides, thio compounds, hexaarylbisimidazole compounds, ketooxime ester pounds, borate compounds, azinium compounds, metallocene compounds, active ester compounds and compounds having a carbon-halogen bond. Many specific examples of such photoinitiators can be found in EP-A 1091247. The best results, in particular the highest sensitivity, are obtained by the claimed combination of an optical brightener as sensitizer and a hexaarylbisimidazole (HABI, dimer of triarylimidazole) as photoinitiator. A procedure for the preparation of HABIs is described in DE 1470 154 and their use in photopolymerizable compositions is documented in EP 24 629, EP 107 792, US 4 410 621, EP 215 453 and DE 3 211 312. Preferred derivatives are e. g. 2,4,5,2',4',5'-hexaphenylbisimidazole, 2,2'-bis(2-chlorophenyl)-4,5,4',5'-tetraphenylbisimidazole, 2,2'-bis(2-bromophenyl)-2,2'-bis(2,4-dichlorophenyl)-4,5,4',5'-tetraphenylbisimidazole, 2,2'-bis(2-chlorophenyl)-4,5,4',5'-tetrakis(3-methoxyphenyl)bisimidazole, 2,2'-bis (2-chlorophenyl)-4,5,4',5'-tetrakis(3,4,5-trimethoxyphenyl)-bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazole, 2,2'-di-o-tolyl-4,5,4',5'-tetraphenylbisimidazole, 2,2'-bis(2-ethoxyphenyl)-4,5,4',5'-tetraphenylbisimidazole and 2,2'-bis(2,6-difluorophenyl)-4,5,4',5'-tetraphenylbisimidazole. The amount of the HABI photoinitiator typically ranges from 0.01 to 30 % by weight, preferably from 0.5 to 20 % by weight, relative to the total weight of the non volatile components of the photopolymerizable composition.

The binder can be selected from a wide series of organic polymers. Compositions of different binders can also be used. Useful binders include for example chlorinated polyalkylene (in particular chlorinated polyethylene and chlorinated polypropylene), polymethacrylic acid alkyl esters or alkenyl esters (in particular polymethyl (meth)acrylate, polyethyl (meth)acrylate, polybutyl (meth)acrylate, polyisobutyl (meth)acrylate, polyhexyl (meth)acrylate, poly(2-ethylhexyl) (meth)acrylate and polyalkyl (meth)acrylate copolymers of (meth) acrylic acid alkyl esters or alkenyl esters with other copolymerizable monomers (in particular with (met)acrylonitrile, vinyl chloride, vinylidene chloride, styrene and/or butadiene), polyvinyl chloride (PVC, vinylchloride/(meth)acrylonitrile copolymers, polyvinylidene chloride (PVDC), vinylidene chloride/(meth)acrylonitrile copolymers, polyvinyl acetate, polyvinyl alcohol, poly (meth)acrylonitrile, (meth)acrylonitrile/styrene copolymers, (meth)acrylamide/alkyl (meth)acrylate copolymers, (meth)acrylonitrile/butadiene/styrene (ABS) terpolymers, polystyrene, poly(α-methylstyrene), polyamides, polyurthanes, polyesters, methyl cellulose, ethylcellulose, acetyl cellulose, hydroxy-(C₁-C₄-alkyl)cellulose, carboxymethyl cellulose, polyvinyl formal and polyvinyl butyral. Particularly suitable are binders that are insoluble in water, but on the other hand are soluble or at least swellable in aqueous-alkaline solutions. Further effective binders are polymers that are soluble in common organic coating solvents.

Particular suitable for the purpose of the present invention are binders containing carboxyl groups, in particular copolymers containing monomeric units of α,β-unsaturated carboxylic acids or monomeric units of α,β-unsaturated dicarboxylic acids (preferably acrylic acid, methacrylic acid, crotonic acid, vinylacetic acid, maleic acid or itaconic acid). By the term "copolymers" are to be understood in the context of the present invention as polymers containing units of at least 2 different monomers, thus also terpolymers and higher mixed polymers. Particular examples of useful copolymers are those containing units of (meth)acrylic acid and units of alkyl (meth)acrylates, allyl (meth)acrylates and/or (meth)acrylonitrile as well as copolymers containing units of crotonic acid and units of alkyl (meth)acrylates and/or (meth)acrylonitrile and vinylacetic acid/alkyl (meth)acrylate copolymers. Also suitable are copolymers containing units of maleic anhydride or maleic acid monoalkyl esters. Among these are, for example, copolymers containing units of maleic anhydride and styrene, unsaturated ethers or esters or unsaturated aliphatic hydrocarbons and the esterification products obtained from such copolymers. Further suitable binders are products obtainable from the conversion of hydroxyl-containing polymers with intramolecular dicarboxylic anhydrides. Further useful binders are polymers in which groups with acid hydrogen atoms are present, some or all of which are converted with activated isocyanates. Examples of these polymers are products obtained by conversion of hydroxyl-containing polymers with aliphatic or aromatic sulfonyl isocyanates or phosphinic acid isocyanates. Also suitable are polymers with aliphatic or aromatic hydroxyl groups, for example copolymers containing units of hydroxyalkyl (meth)acrylates, allyl alcohol, hydroxystyrene or vinyl alcohol, as well as epoxy resins, provided they carry a sufficient number of free OH groups.

The organic polymers used as binders have a typical mean molecular weight M_{w} between 600 and 200 000, preferably between 1 000 and 100 000. Preference is further given to polymers having an acid number between 10 to 250, preferably 20 to 200, or a hydroxyl number between 50 and 750, preferably between 100 and 500. The amount of binder(s) generally ranges from 10 to 90 % by weight, preferably 20 to 80 % by weight, relative to the total weight of the non-volatile components of the composition.

The polymerizable compound can be selected from a wide series of photo-oxidizable compounds. The radically polymerizable compounds contain a tertiary amino group and at least one additional urea and/or urethane group. By the term "urea group" has to be understood in the context of the present invention a group of the formula >N-CO-N< wherein the valences on the nitrogen atoms are saturated by hydrogen atoms and hydrocarbon radicals (with the proviso that not more than one valence on either of the two nitrogen atoms is saturated by one hydrogen atom). However, it is also possible for one valence on one nitrogen atom to be bonded to a carbamoyl (-CO-NH-) group, producing a biuret structure.

Also suitable are compounds further containing a photo-oxidizable amino, urea or thio group, which may be also be a constituent of a heterocyclic ring. Compounds further containing photo-oxidizable enol groups can also be used. Concrete examples of photo-oxidizable groups are triethanolamino, triphenylamino, thiourea, imidazole, oxazole, thiazole, acetylacetonyl, N-phenylglycine and ascorbic acid groups. Particularly suitable compounds are monomers containing photo-oxidizable groups corresponding to the following formula (I):

R₍ₘ₋ₙ₎Q[(-CH₂-CR¹R²-O)ₐ-CO-NH-(X¹-NH-CO-O)_{b}-X²-(O-CO-CR³=CH₂)_{c}]ₙ (I)

wherein
- R: represents a (C₂-C₈) alkyl group, a (C₂-C₈) hydroxyalkyl group or a (C₆-C₁₄) aryl group;
- Q: represents 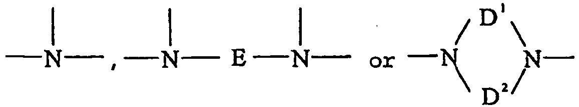
wherein E represents a divalent saturated hydrocarbon group of 2 to 12 carbon atoms, a divalent 5- to 7-membered, saturated iso- or heterocyclic group, which may contain up to 2 nitrogen, oxygen and/or sulfur atoms in the ring, a divalent aromatic mono- or bicyclic isocyclic group of 6 to 12 carbon atoms or a divalent 5- or 6-membered aromatic heterocyclic group; and
D¹ and D² independently represent a saturated hydrocarbon group of 1 to 5 carbon atoms.
- R¹ and R²: independently represent a hydrogen atom, an alkyl or alkoxyalkyl group.
- R³: represents a hydrogen atom, a methyl or ethyl group.
- X¹: represents a straight-chained or brached saturated hydrocarbon group of 1 to 12 carbon atoms.
- X²: represents a (c+1)-valent hydrocarbon group in which up to 5 methylene groups may have been replaced by oxygen atoms.
- a: is an integer from 0 to 4.
- b: is 0 or 1.
- c: is an integer from 1 to 3.
- m: is an integer from 2 to 4.
- n: is an integer from 1 to m.

Compounds of this nature and processes for their preparation are described in EP 287 818. If a compound of general formula (I) contains several radicals R or several radicals according to the structure indicated between square brackets, i. e. if (n-m) > 1 and n>1, these radicals can be identical or different from one another. Compounds according to formula (I) wherein n = m are particularly preferred. In this case, all radicals contain polymerizable groups. Preferably, the index a = 1; if several radicals are present, a cannot be 0 in more than one radical. If R is an alkyl or hydroxyalkyl group, R generally contains 2 to 6, particularly 2 to 4 carbon atoms. Aryl radicals R are in general mononuclear or binuclear, preferably however mononuclear, and may be substituted with (C₁-C₅) alkyl or (C₁-C₅) alkoxy groups. If R¹ and R² are alkyl or alkoxy groups, they preferably contain 1 to 5 carbon atoms. R³ is preferably a hydrogen atom or a methyl group. X¹ is preferably a straight-chained or branched aliphatic and/or cycloaliphatic radical of preferably 4 to 10 carbon atoms. In a preferred embodiment, X² contains 2 to 15 carbon atoms and is in particular a saturated, straight-chained or branched aliphatic and/or cycloaliphatic radical containing this amount of carbon atoms. Up to 5 methylene groups in these radicals may have been replaced by oxygen atoms, in the case of X² being composed of pure carbon chains, the radical generally has 2 to 12 carbon atoms, preferably 2 to 6 carbon atoms. X² can also be a cycloaliphatic group of 5 to 10 carbon atoms, in particular a cyclohexane diyl group. The saturated heterocyclic ring formed by D¹, D² and both nitrogen atoms generally has 5 to 10 ring members in particular 6 ring members. In the latter case the heterocyclic ring is accordingly preferably a piperazine and the radical derived therefrom a piperazine-1,4-diyl radical. In a preferred embodiment, radical E is an alkane diyl group which normally contains about 2 to 6 carbon atoms. Preferably the divalent 5- to 7-membered, saturated, isocyclic group E is a cyclohexane diyl group, in particular a cyclohexane-1,4-diyl group. The divalent, isocyclic, aromatic group E is preferably an ortho-, meta- or para-phenylene group. The divalent 5- or 6-membered aromatic heterocyclic group E, finally, contains preferably nitrogen and/or sulphur atoms in the heterocyclic ring. c is preferably 1, i. e. each radical in the square bracket generally contains only one polymerizable group, in particular only one (meth)acryloyloxy-group.

The compounds of formula (I) wherein b = 1, which accordingly contain two urthane groups in each of the radicals indicated in the square bracket, can be produced in a known way by conversion of acrylic esters or alkacrylic esters which contain free hydroxyl groups with equimolar amounts of diisocyanates. Excess isocyanate groups are then, for example, reacted with tris(hydroxyalkyl)amines, N,N'-bis(hydroxyalkyl) piperazines or N,N,N',N'-tetrakis(hydroxyalkyl)alkylenediamines, in each of which individual hydroxyalkyl groups may have been replaced by alkyl or aryl groups R. If a = 0, the result is a urea grouping. Examples of the hydroxyalkylamine starting materials are diethanolamine, triethanolamine, tris(2-hydroxypropyl)amine, tris(2-hydroxybutyl)amine and alkyl-bis-hydroxyalkylamines. Examples of suitable diisocyanates are hexamethylene diisocyanate, 2,2,4-trimethylhexamethylene diisocyanate, 1,4-cyclohexylene diisocyanate (= 1,4-diisocyanatocyclohexane) and 1,1,3-trimethyl-3-isocyanatomethyl-5-isocyanatocyclohexane. The hydroxy-containing esters used are preferably hydroxyethyl (meth)acrylate, hydroxypropyl (met)acrylate and hydroxyisopropyl (meth)acrylate.

The polymerizable compounds of formula (I) wherein b = 0 are prepared converting the above-described hydroxyalkylamino compounds with isocyanate-containing acrylic or alkacrylic esters. A preferred isocyanate-containing ester is isocyanoto-ethyl (meth)acrylate.

Further polymerizable compounds comprising photooxidisable groups which may be added are compounds according to the following formula (II) :

R₍ₘ₋ₙ₎Q[(-CH₂-CR¹R²-O)_{a'}-(CH₂-CH[CH₂-O-CO-CR³=CH₂]-O)_{b'}-H]ₙ (II)

wherein a' and b' independently represent integers from 1 to 4 and Q, R¹, R², R³, n and m have the same meaning as above and Q can also be a group of the formula >N-E'-N< wherein the radical E' corresponds to the following formula (III) :

-CH₂-CH(OH)-CH₂-[O-(p)C₆H₄-C(CH₃)₂-(p)C₆H₄-CH₂-CH(OH)-CH₂-]_{c} (III)

wherein c has the same meaning as in formula (I) and (p)C₆H₄ represents para-phenylene.

The compounds of formula (II) are prepared analogously to those of formula (I), except that the conversion products of hydroxyalkyl acrylates or alkacrylates and diisocyanates are replaced by the corresponding acrylic and alkacrylic glycide esters. Compounds of formula (III) and processes to their preparation are disclosed in EP 316 706.

Further useful polymerizable compounds containing photooxidisable groups are acrylic and alkacrylic esters of the following formula (IV) :

Q'[(-X^{1'}-CH₂-O)ₐ-CO-NH(-X¹-NH-CO-O)_{b}-X²-O-CO-CR³=CH₂]ₙ (IV)

wherein
Q' represents 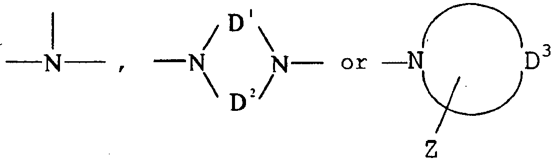 wherein D¹ and D² indepently represent a saturated hydrocarbon group of 1 to 5 carbon atoms and D³ represents a saturated hydrocarbon group of 4 to 8 carbon atoms, which together with the nitrogen atom forms a 5- or 6-membered heterocyclic ring;
X^{1'} represents -CᵢH₂ᵢ- or 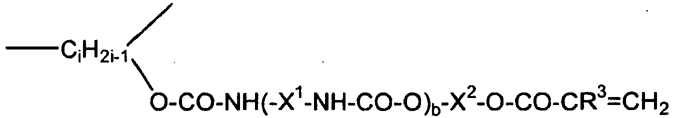 Z represents a hydrogen atom or a radical of the following formula:

-CₖH₂ₖ-O-CO-NH(-X¹-NH-CO-O)_{b}-X²-O-CO-CR³=CH₂ ;

i,k independently represent integers from 1 to 12;
n' represents an integer from 1 to 3;
a is 0 or 1; a is 0 in at least one of the radicals bonded to Q;
X¹, R³, a and b have the same meaning as given in the above formula (I);
X² represents a divalent hydrocarbon group in which up to 5 methylene groups may be replaced by oxygen atoms. In formula (IV) index a is preferably 0 or 1 and i preferably represents a number between 2 and 10. Preferred radicals Q are piperazine-1,4-diyl (D¹ = D² = CH₂-CR₂), piperidine-1-yl (D³ = (CH₂)₅, Z = H) and 2-(2-hydroxyethyl)-piperidine-1-yl (D³ = (CH₂)₅, Z = CH₂CH₂OH).

Of the compounds of formula (IV), those which apart from a urea group contain at least one urthane group are preferred. Here again, by the term "urrea groups" has to be understood the group of formula >N-CO-N< already mentioned above. Compounds of formula (IV) and processes for their preparation are disclosed in EP 355 387.

Also suitable polymerizable compounds which may be added are reaction products of mono- or diisocyanate with multifunctional alcohols, in which the hydroxy groups are partly or completely esterified with (meth)acrylic acid. Preferred compounds are materials, which are synthesized by the reaction of hydroxyalkyl-(meth)acrylates with diisocyanates. Such compounds are basicly know and for instance described in DE 28 22 190 or DE 20 64079.

The amount of polymerizable compound comprising photooxidisable groups generally ranges from 5 to 75 % by weight, preferably from 10 to 65 % by weight, relative to the total weight of the non volatile compounds of the composition.

Moreover, the composition can contain polyfunctional (meth)acrylate or alkyl(meth)acrylate compounds as crosslinking agents. These materials are compounds containing more than 2, preferably between 3 and 6 (meth)acrylate and/or alk(meth)acrylate groups. These include in particular (meth)acrylates of saturated aliphatic or alicyclic trivalent or polyvalent alcohols such as trimethylol ethane, trimethylol propane, pentaerythritol or dipentaerythritol.

The total amount of polymerizable compounds generally ranges from about 10 to 90 % by weight, preferably from about 20 to 80 % by weight, relative to the total weight of the non volatile components of the composition of the present invention.

The following specific example is also a suitable polymerizable compound :

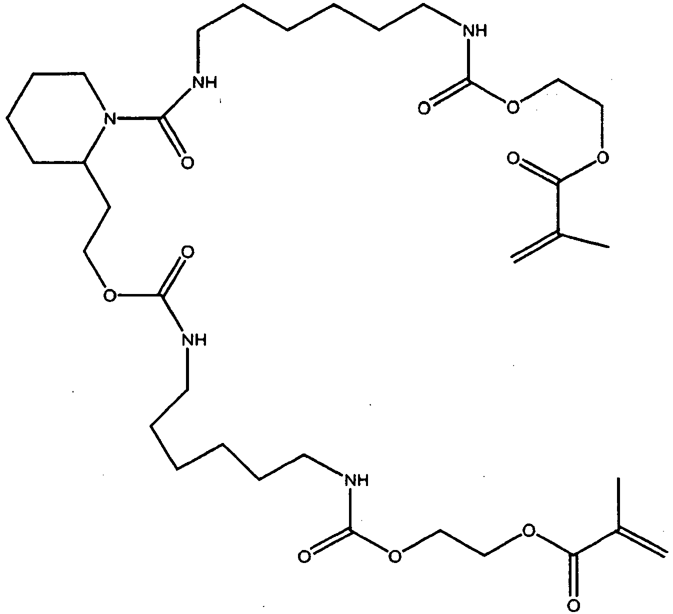

In order to achieve a high sensitivity, it is advantageous to add a radical chain transfer agent as described in EP 107 792 to the composition of the present invention. The preferred chain transfer agents are sulfur-compounds especially thiols like e. g. 2-mercaptobenzothiazole, 2-mercaptobenzoxazole or 2-mercapto-benzimidazole. The amount of chain transfer agent generally ranges from 0.01 to 10 % by weight, preferably from 0.1 to 2 % by weight, relative to the total weight of the non volatile components of the photopolymerizable composition.

Optionally pigments, e.g. predispersed phthalocyanine, can be added to the composition of the present invention for dyeing the composition and the layers produced therewith. Their amount generally ranges from about 1 to 15 % by weight, preferably from about 2 to 7 % by weight. Particularly suitable predispersed phthalocyanine pigments are disclosed in DE 199 15 717 and DE 199 33 139. Preference is given to metal-free phthalocyanine pigments.

In order to adjust the composition according to the invention to specific needs, thermal inhibitors or stabilizers for preventing thermal polymerization may be added. Furthermore additional hydrogen donors, dyes, colored or colorless pigments, color formers, indicators and plasticisers may be present. These additives are expediently selected so that they absorb as little as possible in the actinic range of the imagewise applied radiation.

### EXAMPLES

### Reference Example 1

The following composition was prepared (pw = parts per weight; wt.% = weight percentage) :

| | |
|---|---|
| 4.65 pw | of a solution containing 33.1 wt.% of a methacrylate/ methacrylic acid-copolymer (ratio methylmethacrylate methacrylic acid of 4:1 by weight; acid number: 110 mg KOH/g) in 2-butanone (viscosity 105 mm²/s at 25°C). |
| 3.83 pw | of a solution containing 86.8 wt.% of a reaction product from 1 mole of 2,2,4-trimethyl-hexamethylenediisocyanate and 2 moles hydroxy-ethylmethacrylate (viscosity 3.30 mm²/s at 25°C). |
| 0.36 pw | of triethyleneglycoldimethacrylate. |
| 4.49 pw | of Heliogene blue D 7490^{®} dispersion (9.9 wt.%, viscosity 7.0 mm²/s at 25 °C), trademark of BASF AG. |
| 0.25 pw | of Uvitex OB® as optical brightener, trade mark of Ciba Specialty Chemicals. |
| 0.95 pw | of 2,2'-bis(2-chlorophenyl)-4,4',5,5'-tetraphenyl-1,2-bisimidazole. |
| 0.02 pw | of 2-mercaptobenzoxazole. |
| 0.70 pw | of Edaplan LA 411® (1 wt.% in Dowanol PM®, trade mark of Dow Chemical Company). |
| 32.2 pw | of 2-butanone. |
| 52.5 pw | of propyleneglycol-monomethylether (Dowanol PM®, trade mark of Dow Chemical Company). |

The above composition was coated on an electrochemically roughened and anodically oxidized aluminum sheet, the surface of which has been rendered hydrophilic by treatment with an aqueous solution of polyvinyl phosphonic acid (oxide weight 3 g/m²) and dried for 2 minutes at 100 °C (circulation oven). The resulting thickness of the layer is 1.18 g/m².

On top of the photo layer a solution in water containing 4.9 wt.% of the following composition was coated and dried at 100 °C :

| | |
|---|---|
| 1.0 pw | of partially hydrolyzed polyvinylalcohol (degree of hydrolysis 87.7 %, viscosity 8 mPa.s in a solution of 4 wt.% at 20 °C). |
| 1.0 pw | of fully hydrolyzed polyvinylalcohol (degree of hydrolysis 98.4 %, viscosity 4 mPa.s in a solution of 4 wt.% at 20 °C). |
| 0.5 pw | of polyvinylpyrrolidone (k-value 30). |

The top coat had a dry thickness of 1.6 g/m².

A 400x340 mm sample of the resulting printing plate was imaged on an experimental external drum image setter (drum circumference of 412 mm) with a 5 mW laser diode emitting at 397 nm (PVLS 500^{®} / TUI Optics, München) and having a spot size of 20 µm. The plate was covered by a standard offset test mask (a film element available from UGRA) which contains a 13-step exposure wedge (density increments of 0.15 per step). The power of the unfiltered incident laser light, measured at the surface of the test element, was 65.4 µW. The plate was exposed with a 20 um feed of the laser head in the axial direction of the drum (i.e. circumferential lines are written at a mutual axial distance of 20 µm). The speed of the drum revolution was varied so as to obtain a range of different energy density values at the surface of the test element (480, 600, 800, 1200 and 2400 rpm correspondig to 100, 80, 60, 40 and 20 µJ/cm² respectively).

After imaging the plate was heated for 1 min. at 100 °C and processed in a water based alkaline developer (Agfa EN 231C) at 28 °C (Agfa VSP85 processor, 1 m/min). The density of the coating of the processed plate was then measured at each step of the wedge. The sensitivity of the material is expressed as the minimum energy density that was necessary for a complete hardening of three wedge steps (the coating is considered as being completely hardened when the density of the processed material is at least 97% of the density of of a plate which has been exposed without filter). So a higher number of said minimum energy density represents a lower sensitivity. For present Example 1, the obtained value of said minimum energy density was 45 µJ/cm². The plate showed very good resolution and was capable of a high run length.

### Reference Examples 2-6

The same procedure was followed as described in Example 1 with the proviso that the ingredients given in Table 1 below were used for preparing the coating solution of the light sensitive layer. Ingredients C-G are various optical brighteners according to the present invention.

**Table 1: Composition of the coating solutions (amounts expressed as parts per weight), layer thickness and sensitivity of the resulting printing plates**

| Component | Example 2 | Example 3 | Example 4 | Example 5 | Example 6 |
|---|---|---|---|---|---|
| A | 5.980 | 5.980 | 8.620 | 8.620 | 8.620 |
| B | 5.460 | 5.460 | 5.440 | 5.440 | 5.440 |
| C | 0.320 | - | - | - | - |
| D | - | 0.320 | - | - | - |
| E | - | - | 0.320 | - | - |
| F | - | - | - | 0.320 | - |
| G | - | - | - | - | 0.320 |
| H | 7.450 | 7.450 | 7.200 | 7.200 | 7.200 |
| I | 1.220 | 1.220 | 0.320 | 0.320 | 0.320 |
| J | 0.027 | 0.027 | - | - | - |
| K | - | - | 0.027 | 0.027 | 0.027 |
| L | 0.900 | 0.900 | 0.900 | 0.900 | 0.900 |
| M | 49.58 | 49.58 | 47.84 | 47.84 | 47.84 |
| N | 79.06 | 79.06 | 79.33 | 79.33 | 79.33 |
| coating weigth (g/m²) | 1.17 | 1.16 | 1.20 | 1.20 | 1.20 |
| energy density (*) (µJ/cm²) | 40 | 80 | 40 | 60 | 100 |

| | | | | | |
|---|---|---|---|---|---|
| (*) inversely proportional to sensitivity as explained for Example 1. | | | | | |
| A : a solution containing 33.1 wt.% of a methacrylate/ methacrylic acid copolymer (ratio methylmethacrylate: methacrylic acid of 4:1 by weight; acid number: 110 mg KOH/g) in 2-butanone (viscosity 105 mm²/s at 25°C). | | | | | |
| B : a solution containing 86.8 wt.% of a reaction product from 1 mole of 2,2,4-trimethyl-hexamethylenediisocyanate and 2 moles of hydroxyethylmethacrylate (viscosity 3.30 mm²/s at 25°C). | | | | | |
| C : Hostalux 2902®, trade name of Clariant. | | | | | |
| D : Hostalux MSM®, trade name of Clariant. | | | | | |
| E : 1,4-Distyryl-3,4,5-Trimethoxybenzene. | | | | | |
| F : 2,5-Bis-(4'-diethylaminophenyl)-1,3,4-oxadiazole. | | | | | |
| G : Sky Blue D-286®, trade name of Dye Brite. | | | | | |
| H : Heliogene blue D 7490® dispersion (9.9 wt.%, viscosity 7.0 mm²/s at 25 °C), trade name of BASF AG. | | | | | |
| I : 2,2'-bis(2-chlorophenyl)-4,4',5,5'-tetraphenyl-1,2-bisimidazole. | | | | | |
| J : 2-mercaptobenzothiazole. | | | | | |
| K : 2-mercaptobenzoxazole. | | | | | |
| L : Edaplan LA 411® (1 % in Dowanol PM®, trade mark of Dow Chemical Company). | | | | | |
| M : 2-butanone. | | | | | |
| N : propyleneglycol-monomethylether (Dowanol PM®, trade mark of Dow Chemical Company). | | | | | |

### Example 7-8 and Comparative Examples 1-3

The same procedure was followed as described in Example 1 with the proviso that the ingredients given in Table 2 below were used for preparing the coating solution of the light sensitive layer. Ingredients B and C are optical brighteners according to the present invention. Ingredients D-F are comparative sensitizers.

**Table 2: Composition of the coating solutions (amounts expressed as parts per weight), layer thickness and sensitivity of the resulting printing plates**

| Component | Example 7 | Example 8 | Ref. 1 | Ref. 2 | Ref. 3 |
|---|---|---|---|---|---|
| A | 7.460 | 7.460 | 7.460 | 7.460 | 8.110 |
| B | 4.630 | - | - | - | - |
| C | - | 13.52 | - | - | - |
| D | - | - | 4.020 | - | - |
| E | - | - | - | 4.020 | - |
| F | - | - | - | - | 4.020 |
| G | 0.280 | 0.281 | 0.280 | 0.280 | 0.280 |
| H | 6.180 | 6.190 | 6.180 | 6.180 | 6.180 |
| I | 0.238 | 0.274 | 0.270 | 0.270 | 0.270 |
| J | 0.021 | 0.020 | 0.020 | 0.020 | 0.020 |
| K | 0.770 | 0.770 | 0.770 | 0.770 | 0.770 |
| L | 25.67 | 16.77 | 26.28 | 26.28 | 26.28 |
| M | 44.73 | 44.73 | 44.73 | 44.73 | 44.73 |
| coating weigth (g/m²) | 1.63 | 1.61 | 1.49 | 1.48 | 1.47 |
| energy density (*) (µJ/cm²) | 80 | 100 | (1) | (1) | (1) |

| | | | | | |
|---|---|---|---|---|---|
| (*)inversely proportional to sensitivity as explained for Example 1. (1) no hardening observable at 100 µJ/cm². | | | | | |

| | |
|---|---|
| A : | a solution containing 33.1 wt.% of a methacrylate/ methacrylic acid copolymer (ratio methylmethacrylate: |
| | methacrylic acid of 4:1 by weight; acid number: 110 mg KOH/g) in 2-butanone (viscosity 105 mm²/s at 25°C). |
| B : | a solution containing 86.8 wt.% of a reaction product from 1 mole of 2,2,4-trimethyl-hexamethylenediisocyanate and 2 moles of hydroxyethylmethacrylate (viscosity 3.30 mm²/s at 25°C). |
| C : | a solution in 2-butanone containing 29.7 wt.% of a reaction product from 1 mole of hexamethylenediisocyanate, 1 mole of 2-hydroxyethylmethacrylate and 0.5 mole of 2-(2-hydroxyethyl)-piperidine (viscosity 1.7 mm²/s at 25°C). |
| D : | trimethylolpropane trimethacrylate. |
| E : | ethoxylated bisphenol-A-dimethacrylate (Bisomer E4-BADMA®, trade mark of Inspec U K). |
| F : | dipentaerythritole pentaacrylate (Sartomer SR 399®, trade mark of Cray Valley). |
| G : | 7-Diethylamino-4-methylcoumarin. |
| H : | Heliogene blue D 7490® dispersion (9.9 wt.%, viscosity 7.0 mm²/s at 25 °C), trade mark of BASF AG. |
| I : | 2,2'-bis(2-chlorophenyl)-9,4',5,5'-tetraphenyl-1,2-bisimidazole. |
| J : | 2-mercaptobenzoxazole. |
| K : | Edaplan LA 411® (1 % in Dowanol PM®, trade mark of Dow Chemical Company). |
| L : | 2-butanone. |
| M : | propyleneglycol-monomethylether (Dowanol PM®, trade mark of Dow Chemical Company). |

## Claims

1. A photopolymer printing plate precursor comprising a photosensitive coating, the coating comprising a composition that is photopolymerizable upon absorption of light in the wavelength range between 300 and 450 nm, the composition comprising a binder, a polymerizable compound, a sensitizer and a photoinitiator, **characterized in that** the sensitizer is an optical brightening agent and the photoinitiator is a hexaarylbisimidazole compound, wherein the optical brightening agent has a structure according to one of the following formulae : 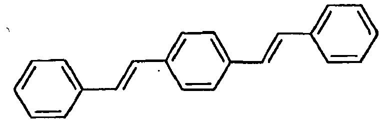 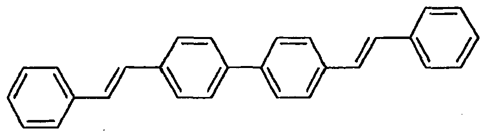 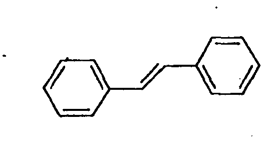 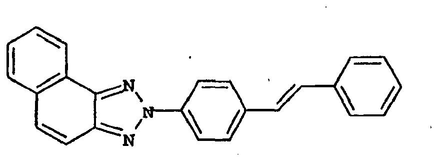 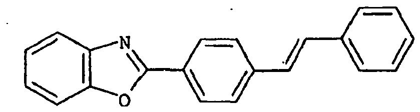 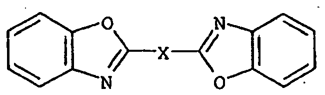 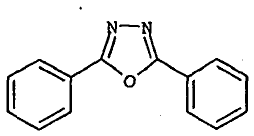 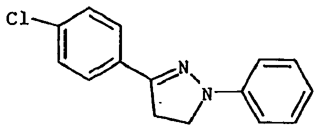 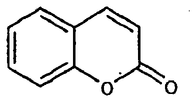 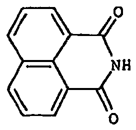 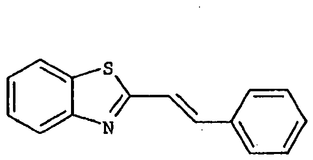 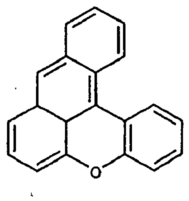 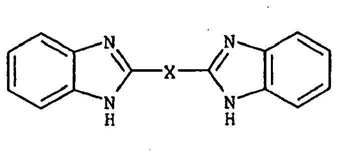 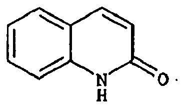 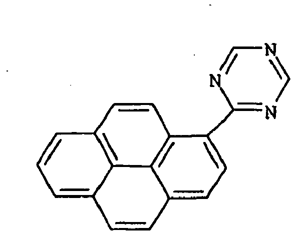 wherein X is one of the following groups, * denoting the position of attachment in the above formulae : 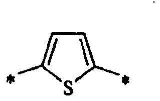 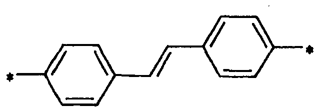 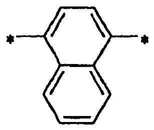 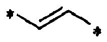 and wherein one or more of the nuclei in each of the above formulae may be independently substituted by one or more groups selected from alkyl, alkoxy, alkylcarbonyl, alkoxycarbonyl, acyloxy, carboxyl, nitrile, amino, hydroxyl, alkylsulfonyl and aminosulfonyl,
and wherein the polymerizable compound contains a tertiary amino group and an urea or urethane group.

2. A photopolymer printing plate precursor according to claim 1 wherein the binder is a polymer containing monomeric units of an α,β-unsaturated carboxylic acid or an α,β-unsaturated dicarboxylic acid.

3. A photopolymer printing plate precursor according to any of the preceding claims further comprising a polyfunctional (meth)acrylate or alkyl(meth)acrylate as a crosslinking agent.

4. A photopolymer printing plate precursor according to any of the preceding claims further comprising a radical chain transfer agent.

5. A photopolymer printing plate precursor according to claim 4 wherein the radical chain transfer agent is a sulfur containing compound.

6. A method of making a lithographic printing plate **characterized in that** it comprises the steps of:
(a) providing a photopolymer printing plate precursor as defined in any of the preceding claims;
(b) exposing said precursor with a laser having an emission wavelength in the range from 300 to 450 nm; and
(c) processing the exposed precursor in an aqueous alkaline developer.

7. The method according to claim 6 wherein the exposure is done with a laser having a wavelength in the range from 380 to 430 nm.

8. The method according to claim 6 wherein the exposure is done with a laser having a wavelength in the range from 390 to 420 nm.

9. The method according to any of the claims 6 to 8 wherein the exposure is done at an energy density, measured on the plate surface, of 100 µJ/cm² or less.

## Patentansprüche

1. Fotopolymerdruckplattenvorstufe, die eine strahlungsempfindliche Beschichtung enthält, wobei die Beschichtung eine bei Absorption von Licht im Wellenlängenbereich von 300 bis 450 nm fotopolymerisierbare Zusammensetzung enthält, wobei die Zusammensetzung ein Bindemittel, eine polymerisierbare Verbindung, ein Sensibilisierungsmittel und einen Fotoinitiator enthält, **dadurch gekennzeichnet, dass** das Sensibilisierungsmittel ein optisches Aufhellmittel ist und der Fotoinitiator eine Hexaarylbisimidazol-Verbindung ist, wobei das optische Aufhellmittel eine Struktur gemäß einer der nachstehenden Formeln halt : 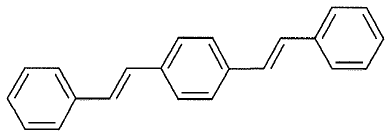 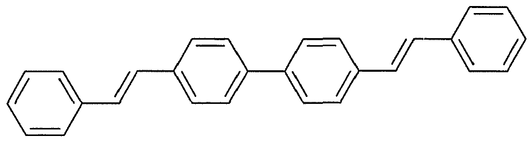 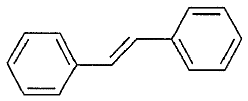 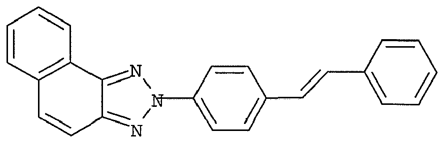 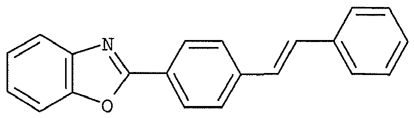 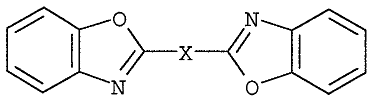 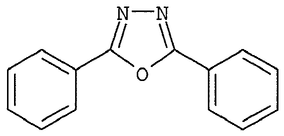 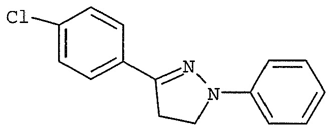 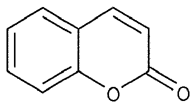 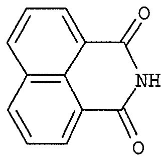 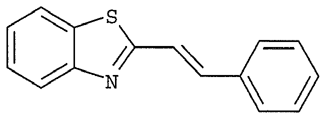 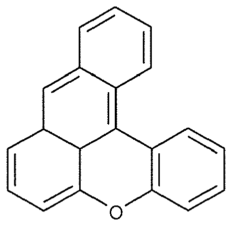 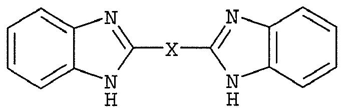 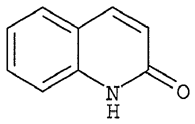 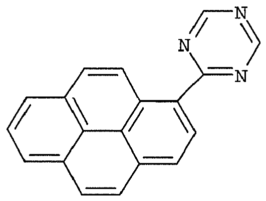 in denen X eine der folgenden Gruppen bedeutet, wobei * die Bindungsstelle in den obigen Formeln bezeichnet : 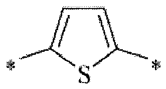 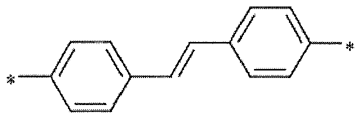 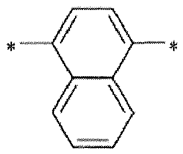 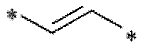 und in denen einer oder mehrere der Ringe in jeder der obigen Formeln unabhängig voneinander durch eine oder mehrere Gruppen aus der Gruppe bestehend aus Alkyl, Alkoxy, Alkylcarbonyl, Alkoxycarbonyl, Acyloxy, Carboxyl, Nitril, Amino, Hydroxyl, Alkylsulfonyl und Aminosulfonyl substituiert sein kann (können), und wobei die polymerisierbare Verbindung eine tertiäre Aminogruppe und eine Harnstoffgruppe oder Urethangruppe enthält.

2. Fotopolymerdruckplattenvorstufe nach Anspruch 1, **dadurch gekennzeichnet, dass** das Bindemittel ein Polymer, das Monomereinheiten einer α,β-ungesättigten Carbonsäure oder einer α,β-ungesättigten Dicarbonsäure enthält, ist.

3. Fotopolymerdruckplattenvorstufe nach einem der vorstehenden Ansprüche, die ferner ein polyfunktionelles (Meth)acrylat oder Alkyl(meth)acrylat als Vernetzungsmittel enthält.

4. Fotopolymerdruckplattenvorstufe nach einem der vorstehenden Ansprüche, die ferner ein Radikalkettenübertragungsmittel enthält.

5. Fotopolymerdruckplattenvorstufe nach Anspruch 4, **dadurch gekennzeichnet, dass** das Radikalkettenübertragungsmittel eine schwefelhaltige Verbindung ist.

6. Verfahren zur Herstellung einer lithografischen Druckplatte, **dadurch gekennzeichnet, dass** es die folgenden Schritte umfasst :
(a) Bereitstellen einer wie nach einem der vorstehenden Ansprüche definierten Fotopolymerdruckplattenvorstufe,
(b) Belichtung der Vorstufe mit einem Laser mit einer Emissionswellenlänge zwischen 300 und 450 nm, und
(c) Entwicklung der belichteten Vorstufe in einem wässrigalkalischen Entwickler.

7. Verfahren nach Anspruch 6, **dadurch gekennzeichnet, dass** die Belichtung mittels eines Lasers mit einer Wellenlänge zwischen 380 und 430 nm erfolgt.

8. Verfahren nach Anspruch 6, **dadurch gekennzeichnet, dass** die Belichtung mittels eines Lasers mit einer Wellenlänge zwischen 390 und 420 nm erfolgt.

9. Verfahren nach einem der Ansprüche 6 bis 8, **dadurch gekennzeichnet, dass** die Belichtung bei einer auf der Plattenoberfläche gemessenen Energiedichte von höchstens 100 µJ/cm² erfolgt.

## Revendications

1. Précurseur d'une plaque d'impression photopolymère comprenant un revêtement photosensible, ledit revêtement contenant une composition photopolymérisable par absorption de lumière d'une longueur d'onde comprise entre 300 et 450 nm, ladite composition contenant un liant, un composé polymérisable, un sensibilisateur et un photo-initiateur, **caractérisé en ce que** le sensibilisateur est un agent de blanchiment optique et que le photo-initiateur est un composé d'hexaarylbisimidazole, ledit agent de blanchiment optique ayant une structure répondant à l'une des formules suivantes : 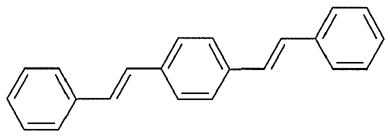 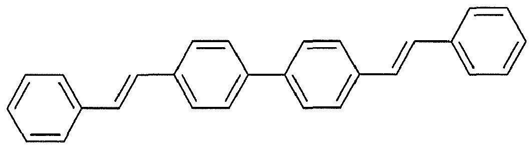 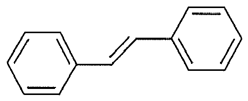 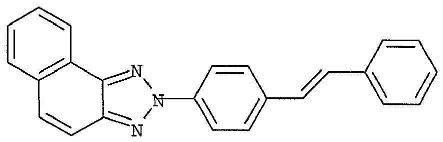 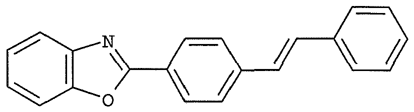 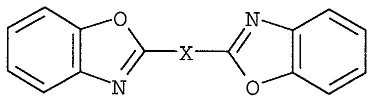 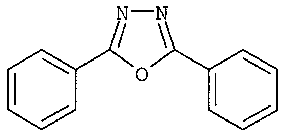 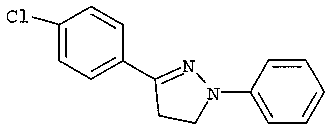 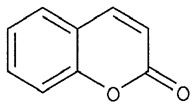 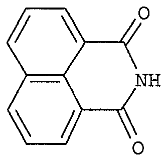 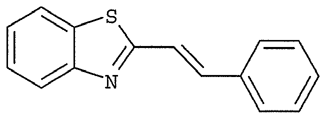 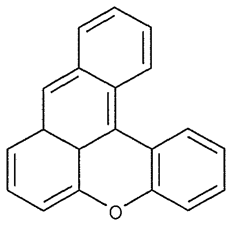 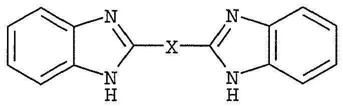 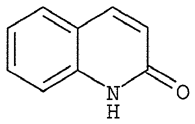 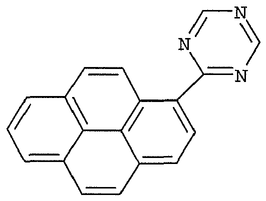 où X représente un des groupes ci-après, où * représente la position de liaison dans les formules reprises ci-dessus : 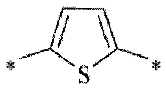 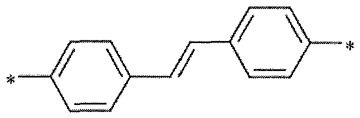 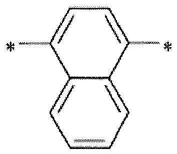 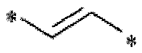 et où l'un ou plusieurs des noyaux dans chacune des formules reprises ci-dessus peu(ven)t être substitué(s), indépendamment l'un de l'autre, par un ou plusieurs groupes choisis parmi le groupe composé d'un groupe alkyle, d'un groupe alkoxy, d'un groupe alkylcarbonyle, d'un groupe alkoxycarbonyle, d'un groupe acyloxy, d'un groupe carboxyle, d'un groupe nitrile, d'un groupe amino, d'un groupe hydroxyle, d'un groupe alkylsulfonyle et d'un groupe aminosulfonyle,
et que le composé polymérisable contient un groupe amino tertiaire et un groupe urée ou un groupe uréthane.

2. Précurseur d'une plaque d'impression photopolymère selon la revendication 1, **caractérisé en ce que** le liant est un polymère comprenant des unités monomères d'un acide carboxylique α,β-insaturé ou d'un acide dicarboxylique α,β-insaturé.

3. Précurseur d'une plaque d'impression photopolymère selon l'une quelconque des revendications précédentes, comprenant en outre un (méth)acrylate polyfonctionnel ou un alkyl(méth)acrylate polyfonctionnel comme agent de réticulation.

4. Précurseur d'une plaque d'impression photopolymère selon l'une quelconque des revendications précédentes, comprenant en outre un agent de transfert de chaîne radicalaire.

5. Précurseur d'une plaque d'impression photopolymère selon la revendication 4, **caractérisé en ce que** l'agent de transfert de chaîne radicalaire est un composé sulfuré.

6. Procédé pour la confection d'une plaque d'impression lithographique, **caractérisé en ce qu'**il comprend les étapes reprises ci-après :
(a) la mise à disposition d'un précurseur d'une plaque d'impression photopolymère tel que défini selon l'une quelconque des revendications précédentes,
(b) l'exposition du précurseur à l'aide d'un laser dont la longueur d'onde d'émission se situe entre 300 et 450 nm, et
(c) le développement du précurseur exposé dans un révélateur alcalin aqueux.

7. Procédé selon la revendication 6, **caractérisé en ce que** l'exposition s'effectue à l'aide d'un laser dont la longueur d'onde se situe entre 380 et 430 nm.

8. Procédé selon la revendication 6, **caractérisé en ce que** l'exposition s'effectue à l'aide d'un laser dont la longueur d'onde se situe entre 390 et 420 nm.

9. Procédé selon l'une quelconque des revendications 6 à 8, **caractérisé en ce que** l'exposition s'effectue à une densité d'énergie maximale, mesurée sur la surface de la plaque, de 100 µJ/cm².
